(19) Europäisches Patentamt
European Patent Office
Office européen des brevets

(11) **EP 2 667 420 A1**

(12) **EUROPEAN PATENT APPLICATION**
published in accordance with Art. 153(4) EPC

(43) Date of publication:
**27.11.2013 Bulletin 2013/48**

(21) Application number: **12736479.2**

(22) Date of filing: **20.01.2012**

(51) Int Cl.:
**H01L 31/042** (2006.01)

(86) International application number:
**PCT/JP2012/051260**

(87) International publication number:
**WO 2012/099257 (26.07.2012 Gazette 2012/30)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **20.01.2011 JP 2011010232
02.08.2011 JP 2011169446**

(71) Applicant: **Dexerials Corporation
Tokyo 141-0032 (JP)**

(72) Inventors:
• **HANAI, Daisuke
Tokyo 1410032 (JP)**
• **NAKAHARA, Koichi
Tokyo 1410032 (JP)**

(74) Representative: **Müller - Hoffmann & Partner
Patentanwälte
Innere Wiener Strasse 17
81667 München (DE)**

(54) **SOLAR CELL MODULE AND METHOD OF MANUFACTURING SOLAR CELL MODULE**

(57)    The present invention prevents corrosion at a contact portion between conductive particles and each of a tab lead and an electrode, thereby maintaining power generation efficiency. A solar cell module is provided with a plurality of solar cells (2); and at least one tab lead (3), the at least one tab lead configured to a plurality of the solar cells (2) to each other in such a manner that each of the at least one tab lead is bonded to electrodes (11) and (13) formed on a front surface of corresponding one of the solar cells (2) and a back surface of another one of the solar cells (2) adjacent to said solar cell (2), respectively, via an electroconductive adhesive (17) containing conductive particles (23), wherein a surface of the conductive particles (23) is made of the same kind of a conductor as a conductor constituting a connection surface of the at least one tab lead (3) and a conductor constituting the electrodes (11) and (13).

FIG.2

EP 2 667 420 A1

**Description**

Field of the Invention

The present invention relates to a solar cell module in which a plurality of solar cells is connected by a tab lead, and particularly relates to a solar cell module in which an electrode of a solar cell is connected to a tab lead via an electroconductive adhesive containing conductive particles, and relates to a method of manufacturing the solar cell module.

The present application asserts priority rights based on JP Patent Application 2011-10232 filed in Japan on January 20, 2011, and JP Patent Application 2011-169446 filed in Japan on August 2, 2011. The total contents of disclosure of the Patent Application of the senior filing date are to be incorporated by reference into the present application.

Background of the Invention

For example, in a crystalline silicon solar cell module, a plurality of solar cells which adjoin each other is connected by a tab lead used as an inter-connector. One end portion of a tab lead is connected to a front surface electrode of a solar cell, while the other end portion of the tab lead is connected to a back surface electrode of another solar cell adjacent to said solar cell, and thus each of the solar cells is connected in series. In this case, one surface side of one end portion of the tab lead is bonded to front surface electrode of a solar cell, while the other surface side of the other end portion of the tab lead is bonded to back surface electrode of another solar cell adjacent to said solar cell.

Specifically, in the solar cell, by screen printing or the like of silver paste, a bus bar electrode is formed in a light incident surface, while an Ag electrode is formed in a connecting portion of a back surface. Note that, in an area other than the connecting portion of the back surface of the solar cell, an Al electrode or an Ag electrode is formed.

The tab lead is formed by providing solder-coating layers on both surfaces of ribbon-shaped copper foil. Specifically, the tab lead is formed in such a manner that copper foil rolled spread to approximately 0.05 to 0.2 mm thickness is slit or a copper wire is rolled to a flat shape, and the thus-obtained 1 to 3-mm-wide straight-angle copper wire is solder-plated or dip-soldered.

Connection of the solar cell to the tab lead is performed in such a manner that the tab lead is arranged on the corresponding electrode of the solar cell, and hot-pressed by a heat bonder, and accordingly solder formed on the surface of the tab lead is melted and cooled (PTL 1).

However, the connection by soldering is performed at a high temperature of approximately 260 degrees C, and therefore, due to a warp or a crack of a solar cell; internal stress produced at a connecting portion of a tab lead to the corresponding front surface electrode and to the corresponding back surface electrode; a residue of a flux; and the like, there is a concern about the possibility that connection reliability between the tab lead and the corresponding front electrode and the corresponding back surface electrode of the solar cell is reduced.

Then, conventionally, for connection of the corresponding front surface electrode and the corresponding back surface electrode of the solar cell to a tab lead, an electroconductive adhesive film which is connectable by thermocompression-bonding at a comparatively low temperature has been used (PTL 2). As such electroconductive adhesive film, there has been used a film which is obtained in such a manner that electroconductive particles having an average particle diameter of the order of several $\mu$m and having a spherical or scale shape are dispersed in a heat-curing type binder resin composite to produce a film.

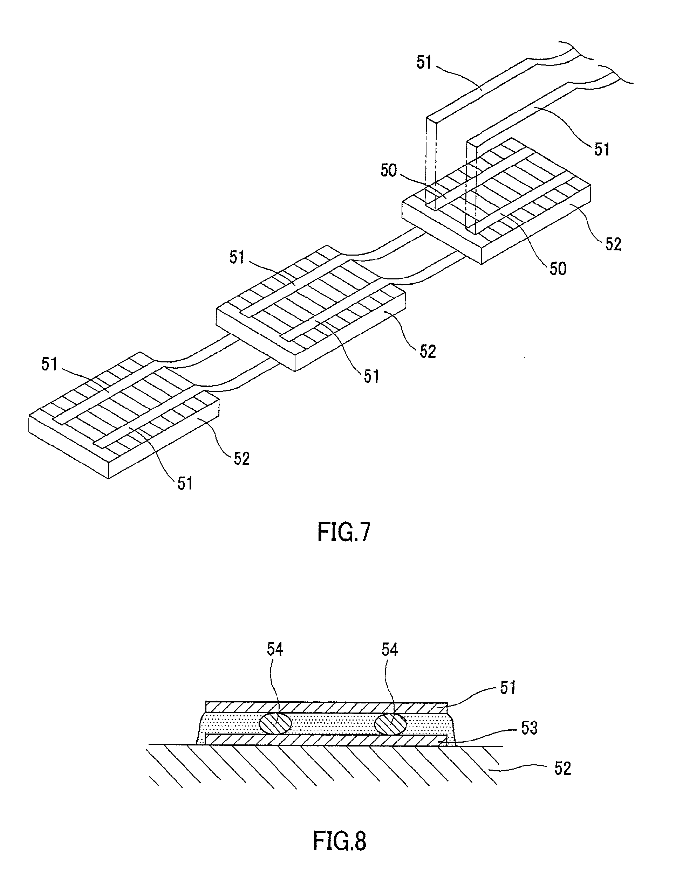

As shown in Fig. 7, an electroconductive adhesive film 50 is arranged to be disposed between a corresponding front surface electrode and a corresponding back surface electrode and a tab lead 51, and then hot-pressed from above the tab lead 51 by a heat bonder. Thus, as shown in Fig. 8, in the electroconductive adhesive film 50, binder resin becomes fluid and flows out from between an electrode and a tab lead 51, and, at the same time, conductive particles 54 are sandwiched between the electrode 53 and the tab lead 51, thereby bringing electrical continuity therebetween, and the binder resin is heat-cured in this state. Thus, a string in which a plurality of solar cells 52 is connected in series by the tab lead 51 is formed.

A plurality of solar cells 52 in which the tab lead 51 is connected to the corresponding front surface electrode and the corresoinding back surface electrode is connected to by using the electroconductive adhesive film 50 is sealed between a front surface protective material having translucency, such as glass or translucent plastics, and a back surface protective material made of a film of PET (Poly Ethylene Terephthalate) or the like, by a sealing material having translucency, such as ethylene-vinyl acetate copolymer resin (EVA).

Prior-Art Documents

Patent Document

PTL 1: Japanese Patent Application Laid-Open No. 2004-356349
PTL 2: Japanese Patent Application Laid-Open No. 2008-135654

Summary of the Invention

In the connection of the tab lead 51 to the corresponding electrode 53 formed on front and back surfaces of a solar cell 52 by using an electroconductive adhesive film 50, conductive particles 54 and each of the tab lead 51 and the electrode 53 are made electrically continuous by bringing mutually different metals into contact. When a solar cell module is actually used, it is feared that the solar cell module could be repeatedly exposed to a corrosive environment of high temperature and high humidity over a long period of time. Then, in a contact portion between the conductive particles 54 and each of the tab lead 51 and the electrode 53, wherein a different kinds of metals are electrically contacted with each other, it is feared that what is called contact corrosion between different kinds of metals could be caused, thereby reducing power generation efficiency.

Accordingly, the present invention aims at providing a solar cell module wherein, even if the solar cell module is exposed to an environment of high temperature and high humidity, corrosion of the contact portion of conductive particles with each of a tab lead and an electrode can be prevented and thereby power generation efficiency is maintained; and at providing a method of manufacturing the solar cell module.

To solve the above-mentioned problem, a solar cell module according to the present invention comprises a plurality of solar cells and at least one tab lead configured to connect the plurality of solar cells to each other in such a manner that each of the at least one tab lead is bonded to an electrode formed on a front surface of corresponding one of the solar cells and to an electrode formed on a back surface of another one of the solar cells which is adjacent to said solar cell, via an electroconductive adhesive containing conductive particles, wherein the surfaces of the conductive particles are made of a same kind of a conductor as at least any one of a conductor constituting a connection surface of the at least one tab lead and a conductor constituting the electrode.

A method of manufacturing a solar cell module according to the present invention comprises the steps of: arranging one end portion of a tab lead on a front surface electrode of a solar cell via an electroconductive adhesive containing conductive particles, while arranging the other end portion of the tab lead on a back surface electrode of another solar cell adjacent to said solar cell via an electroconductive adhesive containing conductive particles; and hot-pressing the tab lead on the front surface electrode and the back surface electrode, thereby bonding the tab lead to the front surface electrode and the back surface electrode by the electroconductive adhesive, wherein a surface of the conductive particles is made of the same kind of a conductor as at least any one of a conductor constituting a connection surface of the tab lead and a conductor constituting the electrode.

Effects of Invention

According to the present invention, the same kind of a conductor as a conductor constituting a connection surface of a tab lead or a conductor constituting an electrode of a solar cell, that is, a conductor having a standard electrode potential similar thereto is used for conductive particles contained in an electroconductive adhesive, and therefore, even if a solar cell module is exposed under a corrosive environment of high temperature and high humidity, a corrosion potential difference between conductors whose standard electrode potentials approximate each other are smaller, and accordingly occurrence of contact corrosion between different kinds of metals can be controlled, whereby a decrease in power generation efficiency can be effectively prevented and, at the same time, connection reliability can be improved.

Brief Description of Drawings

Figure 1 is an exploded perspective view of a solar cell module.
Figure 2 is a cross-sectional view illustrating a string of a solar cell.
Figure 3 is a plan view illustrating a back surface electrode of a solar cell and a connection portion thereof.
Figure 4 is a cross-sectional view illustrating an electroconductive adhesive film.

Figure 5 illustrates an electroconductive adhesive film wound up in reel form.

Figure 6 explains Examples.

Figure 7 is a perspective view illustrating the prior art solar cell module.

Figure 8 is a cross-sectional view illustrating a state that a tab lead is connected to an electrode via conductive particles.

Detailed Description of the Invention

Hereinafter, a solar cell module and a method for manufacturing the solar cell module according to the present invention will be explained in detail with reference to the drawings. Note that the present invention is not limited only to the following embodiment, and it is a matter of course that various changes can be made within the scope not deviating from the gist of the present invention. Moreover, the drawings are schematic and the ratio of each dimension and the like may be different from the actual ratio thereof. Specific dimensions and the like should be determined in consideration of the following explanation. Furthermore, it is a matter of course that there is sometimes a difference in relation or ratio of dimension between the drawings.

[Solar Cell Module]

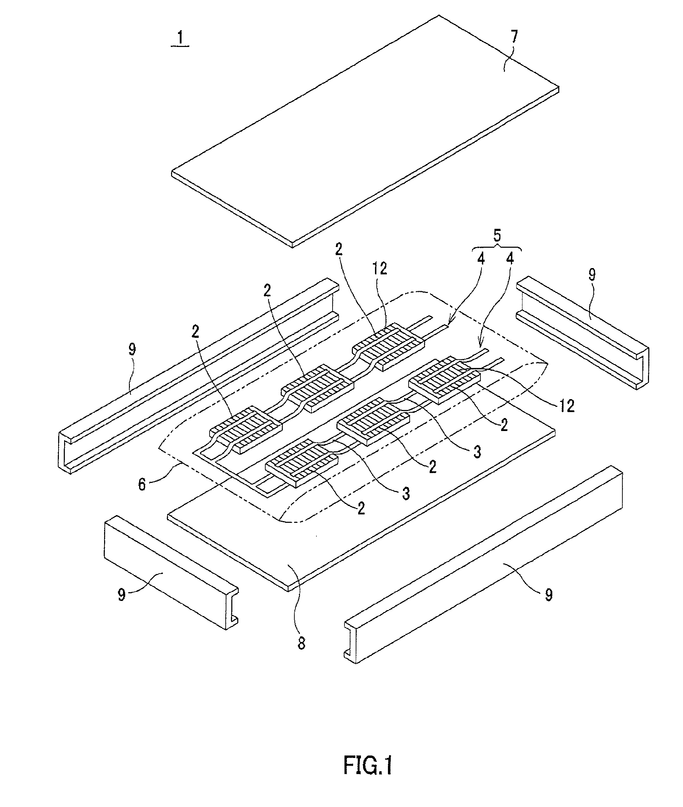

As shown in Fig. 1 to Fig. 3, a solar cell module 1 according to the present invention has a string 4 configured such that a plurality of solar cells 2 is connected in series by a tab lead 3 used as an interconnector, and is provided with a matrix 5 configured such that a plurality of the strings 4 are arranged. The solar cell module 1 is formed in such a manner that the matrix 5 is sandwiched with a sealing adhesive sheet 6, and laminated together with a front surface cover 7 provided at a side of a light incident surface and a back sheet 8 provided at a back surface side, and finally a metal flame 9 made of aluminum or the like is attached to the circumference thereof.

Examples of the sealing adhesive include a translucent sealing material, such as ethylene-vinyl acetate copolymer resin (EVA). Examples of the front surface cover 7 include a translucent material, such as glass or translucent plastics. Examples of the back sheet 8 include a laminated material configured such that glass or aluminum foil is sandwiched with a resin film.

Each of the solar cells 2 of the solar cell module has a photoelectric conversion element 10. There may be used each type of the photoelectric conversion elements 10 for crystalline silicon solar cells including a single crystal type silicon photoelectric conversion element or a polycrystal type photoelectric conversion element; thin-film silicon solar cells made of amorphous silicon; multi-junction-type thin-film silicon solar cells in which a cell made of amorphous silicon and a cell made of microcrystal silicon or amorphous silicon germanium are laminated; what is called compound thin film solar cells; organic type solar cells; quantum dot type solar cells; and the like.

The photoelectric conversion element 10 is provided, at a side of a light incident surface, with a finger electrode 12 which collects an electric current generating inside and a bus bar electrode 11 which collects the electric current of the finger electrode 12. The bus bar electrode 11 and the finger electrode 12 are formed in such a manner that an Ag paste, for example, is applied to a light incident surface of the solar cell 2 by screen-printing or the like, and then baked. The finger electrode 12 is formed over the whole of the light incident surface in such a manner that, for example, a plurality of lines having a width of approximately 50 to 200 $\mu$m are arranged in approximately parallel at predetermined intervals, for example, at intervals of 2 mm. The bus bar electrode 11 is formed so as to intersect at approximately right angles to the finger electrode 12, and a plurality of the bus bar electrodes 11 is formed depending on an area of the solar cell 2.

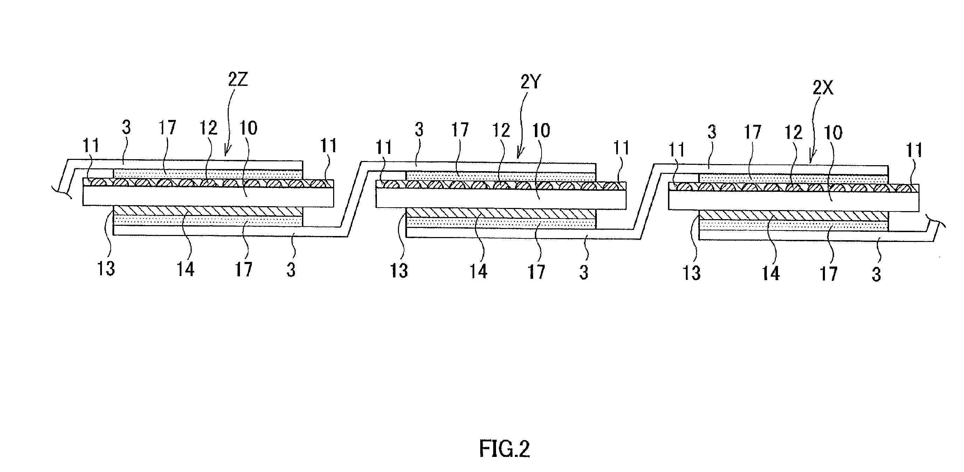

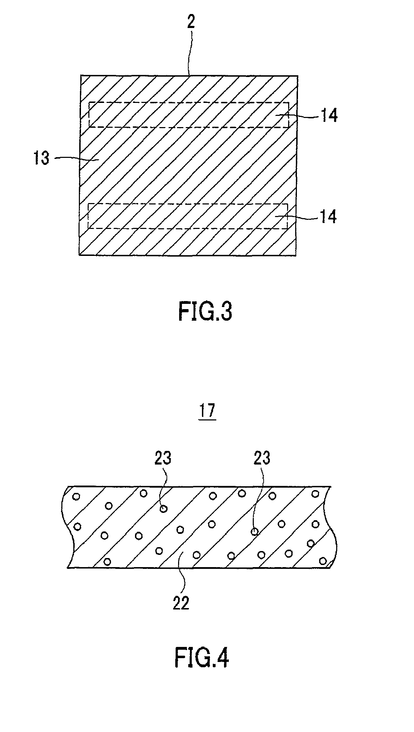

In the photoelectric conversion element 10, at a back surface opposite to the light incident surface, a back surface electrode 13 made of aluminum or silver is formed. As shown in Fig. 2 and Fig. 3, the back surface electrode 13 is configured such that, for example, an electrode made of aluminum or silver is formed on a back surface of the solar cell 2 by screen-printing, sputtering, or the like. The back surface electrode 13 has a tab lead connection portion 14 in which a tab lead 3 is connected thereto via an electroconductive adhesive film 17 mentioned later.

A bus bar electrode 11 formed on a front surface of a solar cell 2 is electrically connected, by a tab lead 3, to a back surface electrode 13 of another solar cell 2 adjacent to said solar cell 2, whereby a string 4 in which the solar cells 2 are connected in series is constituted. The tab lead 3 is connected to the corresponding bus bar electrode 11 and the corresponding back surface electrode 13 via an electroconductive adhesive film 17 mentioned later.

[Tab Lead]

As shown in Fig. 2, a tab lead 3 is a long-ruler-shaped conductive base material to electrically connect between solar cells 2X, 2Y, and 2Z, which adjoin each other. The tab lead 3 is formed in such a manner that, for example, copper foil or aluminum foil rolled spread to approximately 50 to 300 $\mu$m thickness is slit, or a thin metal wire made of copper, aluminum, or the like is rolled spread in the shape of a plate, whereby a straight-angle copper wire having a width of 1 to 3 mm width, which is almost the same width as the electroconductive adhesive film 17, is obtained. Then, this straight-angle copper wire is plated with gold, silver, tin, solder, or the like, thereby forming the tab lead 3.

[Electroconductive Adhesive Film]

As shown in Fig. 4, an electroconductive adhesive film 17 is a heat-curing binder resin layer in which spherical conductive particles 23 are contained in a binder resin 22 at high density. From a viewpoint of squeezing property, in the electroconductive adhesive film 17, the binder resin 22 preferably has a minimum melt viscosity of 100 to 100000 Pa·s. When a minimum melt viscosity of the electroconductive adhesive film 17 is too low, the resin flows at the steps of from low compression bonding to curing, whereby a poor connection and a flash to a light incident surface are easily caused, and also reduction in light receiving rate is caused. Meanwhile, when a minimum melt viscosity thereof is too high, a defect easily generates at the time of film pasting, and a bad influence is sometimes given to connection reliability. Note that a minimum melt viscosity can be measured by charging a rotational viscometer with a predetermined quantity of a sample and raising a temperature at a predetermined heating rate.

[Conductive Particles]

Examples of the conductive particles 23 used for the electroconductive adhesive film 17 include particles of metal, such as nickel, gold, silver, and copper, and particles obtained by using resin particles as a core material and plating an outermost layer thereof with gold or the like.

In the conductive particles 23 according to the present invention, a surface of thereof is made of the same kind of a conductor as at least any one of a conductor constituting a connection surface of the tab lead 3 and a conductor constituting the bus bar electrode 11 and the back surface electrode 13, preferably made of the same conductor as a conductor constituting a connection surface of the tab lead 3 and a conductor constituting the bus bar electrode 11 and the back surface electrode 13.

Here, the connection surface of the tab lead 3 indicates a surface connected to the bus bar electrode 11 or the back surface electrode 13 via the conductive particles 23. In other words, in the case where the connection portion of the tab lead 3 is formed by coating a base material, such as copper foil, with a conductor, such as solder, the connection surface of the tab lead 3 is a coated outermost layer, while in the case where the tab lead 3 is not coated with a conductor, the connection surface of the tab lead 3 is a surface of the base material.

The same kind of a conductor as a conductor constituting a connection surface of the tab lead 3 or a conductor constituting the bus bar electrode 11 indicates a conductor whose standard electrode potential approximates that of a conductor constituting the connection surface of the tab lead 3 or a conductor constituting the bus bar electrode 11 and the back surface electrode 13. A corrosion potential difference between conductors whose standard electrode potentials approximate each other is smaller, and accordingly occurrence of contact corrosion between different kinds of metals can be controlled.

Furthermore, the connection surface of the tab lead 3, and the bus bar electrode 11 and the back surface electrode 13 are constituted by the same kind of metal, and in addition, the conductive particles 23 used for the electroconductive adhesive film 17 are also made of the same kind of metal or the same metal as the connection surface of the tab lead 3, and the bus bar electrode 11 and the back surface electrode 13, whereby occurrence of contact corrosion between different kinds of metals can be more effectively controlled.

For example, when the tab lead 3 is formed by solder-coating a copper base material, and the bus bar electrode 11 and the back surface electrode 13 are formed by screen-printing or the like and then being baked with an Ag paste, Ag particles or solder particles are used as the conductive particles 23, whereby occurrence of contact corrosion between different kinds of metals at a connection portion between the tab lead 3 and the bus bar electrode 11 can be controlled, and decrease in power generation efficiency can be prevented.

Also, for example, when the tab lead 3 is formed by Ag-coating a copper base material, and the bus bar electrode 11 and the back surface electrode 13 are formed by screen-printing or the like and then being baked with an Ag paste, Ag particles are used as the conductive particles 23, whereby occurrence of contact corrosion between different kinds of metals at a connection portion between the tab lead 3 and the bus bar electrode 11 or the back surface electrode 13 can be more effectively controlled, and decrease in power generation efficiency can be prevented.

Note that the conductive adhesive film 17 preferably has a viscosity in a range from 10 to 10000 kPa·s, and more preferably, from 10 to 5000 kPa·s, at around normal temperature. By setting the viscosity of the conductive adhesive film 17 in a range from 10 to 10000 kPa·s, in the case where the conductive adhesive film 17 is wound in a reel shape, it becomes possible to prevent blocking due to so-called protrusion and also to maintain a predetermined tackiness.

[Binder Resin]

Although not particularly limited as long as the above-mentioned properties are not impaired, the composition of a binder resin 22 of the conductive adhesive film 17 preferably includes a film-forming resin, a liquid epoxy resin, a potential curing agent and a silane coupling agent.

The film-forming resin corresponds to a high-molecular-weight resin having an average molecular weight of 10000 or more, and from the viewpoint of film forming characteristics, preferably has an average molecular weight of approximately 10000 to 80000. As the film-forming resin, various resins, such as epoxy resins, modified epoxy resins, urethane resins, phenoxy resins, may be used, and among these, from the viewpoints of film-forming state, connection reliability, and the like, phenoxy resins are preferably used.

The liquid epoxy resin is not particularly limited as long as having flowability at normal temperature, and any commercially-available epoxy resin may be used. Specific examples of such epoxy resin include naphthalene-type epoxy resins, biphenyl-type epoxy resins, phenol novolak-type epoxy resins, bisphenol-type epoxy resins, stilbene-type epoxy resins, triphenol methane-type epoxy resins, phenol aralkyl-type epoxy resins, naphthol-type epoxy resins, dicyclopentadiene-type epoxy resins, and triphenyl methane-type epoxy resins. These may be used alone, or two or more kinds of these may be used in combination. Moreover, organic resins, such as acrylic resins, may be used in combination as appropriate.

As the potential curing agent, various curing agents, such as a heat curing agent and a UV-curing agent, may be used. The potential curing agent does not normally react, but is activated with a certain trigger and starts to react. Examples of the trigger include heat, light, and pressure, and any of these may be selected and used according to the application. In the present invention, particularly, a heat-curing type potential curing agent is preferably used, and fully-cured by being hot-pressed against the bus bar electrode 11 and the back surface electrode 13. In the case where a liquid epoxy resin is used, a potential curing agent made of imidazoles, amines, sulfonium salts, onium salts, or the like, may be used.

As the silane coupling agent, epoxy-based, amino-based, mercapto-sulfide-based, or ureide-based agents may be used. In the present embodiment, among these, an epoxy-based silane coupling agent is preferably used. Thus, an adhesive property on an interface between an organic material and an inorganic material can be improved.

Moreover, as another additive composition, an inorganic filler is preferably contained. When an inorganic filler is contained therein, the flowability of a resin layer at the time of compression-bonding can be adjusted so that a particle capture rate can be improved. As the inorganic filler, materials, such as silica, talc, titanium oxide, calcium carbonate, and magnesium oxide, may be used, and the kind of the inorganic filler is not particularly limited.

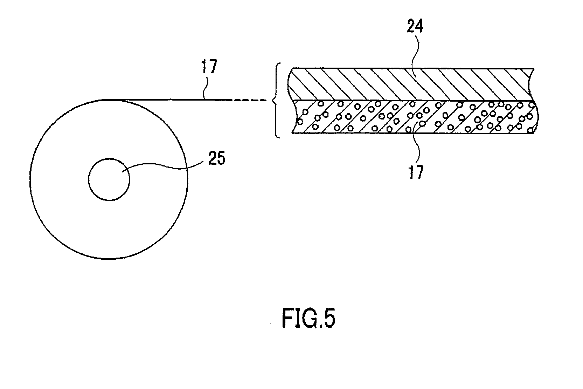

Fig. 5 is a schematic diagram showing an example of a product configuration of the conductive adhesive film 17. This conductive adhesive film 17 is obtained in such a manner that a binder resin layer 22 is laminated on a release base material 24 and formed into a tape shape. This tape-shaped conductive adhesive film is wound and laminated on a reel 25 so as to make the release base material 24 arranged at an outer periphery side. The release base material 24 is not particularly limited, and PET (PolyEthylene Terephthalate), OPP (Oriented Polypropylene), PMP (Poly-4-methlpentene-1), PTFE (Polytetrafluoroethylene), or the like may be used. Also, the conductive adhesive film 17 may be configured to have a transparent cover film on the binder resin layer 22.

In this case, the above-mentioned tab lead 3 may be used as the cover film to be pasted on the binder resin 22. In the electroconductive adhesive film 17, the binder resin 22 is laminated on a principal surface of the tab lead 3. Thus, by laminating and integrating the tab lead 3 and the electroconductive adhesive film 17 beforehand, at the time of actual use, the release base material 24 is peeled off and the binder resin 22 of the electroconductive adhesive film 17 is pasted on the bus bar electrode 11 and the tab lead connection portions 14 of the back surface electrode 13, whereby connection of the tab lead 3 to the corresponding electrode 11 and the corresponding electrode 13 can be achieved.

The above explains an electroconductive adhesive film having a film shape, but there is no problem to use an electroconductive adhesive paste having a paste form. In the present invention, the electroconductive adhesive film 17 having a film shape and containing conductive particles, and a conductive adhesive paste having a paste form and containing conductive particles are defined as "electroconductive adhesives".

Note that the conductive adhesive film 17 is not limited to have a reel shape, and may be formed into a strip shape corresponding to a shape of the bus bar electrode 11 and the tab lead connection portion 14 of the back surface electrode 13.

As shown in Fig. 5, in the case where the conductive adhesive film 17 is provided as a reel product rolled up, by setting the viscosity of the conductive adhesive film 17 in a range from 10 to 10000 kPa·s, the conductive adhesive film 17 can be prevented from being deformed, and predetermined dimensions thereof can be maintained. Moreover, also in the case where the conductive adhesive film 17 has a strip shape and two or more sheets thereof are laminated, the deformation can be prevented and predetermined dimensions thereof can be maintained.

[Manufacturing Method]

To obtain the above-mentioned electroconductive adhesive film 17, conductive particles 23, a film-forming resin, a liquid epoxy resin, a potential curing agent, and a silane coupling agent are dissolved in a solvent. As the solvent, toluene, ethyl acetate, or the like, or a mixed solvent of these, may be used. A resin forming solution obtained by the dissolution is applied onto a release sheet and the solvent is volatilized, whereby the electroconductive adhesive film 17 is obtained.

Then, the electroconductive adhesive film 17 is cut to make 2 pieces for a front surface electrode and 2 pieces for a back surface electrode, each having a predetermined length, and temporarily pasted at the predetermined positions on the back and front surfaces of the solar cell 2. At this time, the electroconductive adhesive film 17 is temporarily pasted onto each of the bus bar electrode 11 and the tab lead connection portion 14 of the back surface electrode 13, a plurality of the bus bar electrodes 11 and the tab lead connection portions 14 being formed almost in parallel on each of the surfaces of the solar cell 2. Note that, in the case where a conductive adhesive paste is used as an electroconductive adhesive, the conductive adhesive paste is applied onto the bus bar electrode 11 and the tab lead connection portion 14 of the back surface electrode 13.

Next, in the same manner, the tab lead 3 cut into the predetermined length is arranged to overlap on the electroconductive adhesive film 17. Then, the electroconductive adhesive film 17 is hot-pressed from above the tab lead 3 by a  heat bonder at the predetermined temperature and pressure, whereby an excessive binder resin 22 flows out from between each of the electrodes 11 and 13 and the tab lead 3 while conductive particles 23 are sandwiched between the tab lead 3 and the corresponding electrode 11 and the corresponding electrode 13, and the binder resin 22 cures in this state. Thus, the electroconductive adhesive film 17 allows the tab lead 3 to adhere on each of the electrodes, and at the same time, the conductive particles 23 come into contact with the bus bar electrode 11 and the back surface electrode 13, thereby achieving electrical connection.

Thus, the solar cells 2 are connected one by one by the tab lead 3 to form a string 4 and a matrix 5. Next, a plurality of the solar cells 2 constituting the matrix 5 is sealed between a front surface cover 7 having translucency, such as glass or translucent plastics, and a back sheet 8 made of glass, PET (Poly Ethylene Terephthalate) film, or the like, by a sealing material sheet 6 having translucency, such as ethylene-vinyl acetate copolymer resin (EVA). Finally, a metal flame 9 made of aluminum or the like is attached to the circumference to form a solar cell module 1.

[Bus-bar-less]

The solar cell module 1 may have the above-mentioned configuration such that a bus bar electrode 11 is arranged so as to intersect at approximately right angles to a finger electrode 12 at a side of a light incident surface of a solar cell 2, and an electroconductive adhesive and a tab lead 3 are laminated on the bus bar electrode 11, or may have a so-called bus-bar-less structure such that, without providing a bus bar electrode 11, an electroconductive adhesive and a tab lead 3 are laminated so as to intersect at approximately right angles to a finger electrode 12. In this case, a surface of conductive particles 23 is made of the same kind of a conductor as at least any one of a conductor constituting a connection surface of the tab lead 3 and a conductor constituting the finger electrode 12 and the back surface electrode 13.

[Batch Lamination]

The solar cell module 1 may be formed by the above-mentioned method wherein the electroconductive adhesive and the tab lead 3 are arranged on the corresponding electrode 11 and the corresponding electrode 13 of the solar cell 2, and then the tab lead 3 is hot-pressed from above by a heat bonder, or may be formed by a method wherein an electroconductive adhesive, a tab lead 3, and a translucent sealing sheet, such as EVA, to seal a solar cell 2 are laminated successively on each of the front and back surfaces of a solar cell 2, and laminated together using a pressure reduction laminator, whereby the tab lead 3 is hot-pressed on the corresponding electrode 11 and the corresponding electrode 13.

[Effects of Invention]

In such solar cell module 1, the same kind of a conductor as a conductor constituting a connection surface of a tab lead 3 or a conductor constituting electrodes 11 and 13 of a solar cell 2, that is, a conductor having a standard electrode potential similar thereto, is used for conductive particles 23 contained in an electroconductive adhesive film 17, and therefore, even if the solar cell module is exposed under a corrosive environment of high temperature and high humidity, a corrosion potential difference between conductors whose standard electrode potentials approximate each other are smaller, and accordingly occurrence of contact corrosion between different kinds of metals can be controlled and a decrease in power generation efficiency can be prevented.

Furthermore, in the solar cell module 1, the connection surface of the tab lead 3 and the electrodes 11 and 13 of the solar cell 2 are constituted of the same kind of metal, and also, the conductive particles 23 used for the electroconductive adhesive film 17 are constituted of the same kind of metal as the one used for the connection surface of the tab lead 3 and the electrodes 11 and 13 of the solar cell 2, whereby occurrence of contact corrosion between different kinds of metals can be more effectively controlled and a decrease in power generation efficiency can be more effectively prevented.

<Examples >

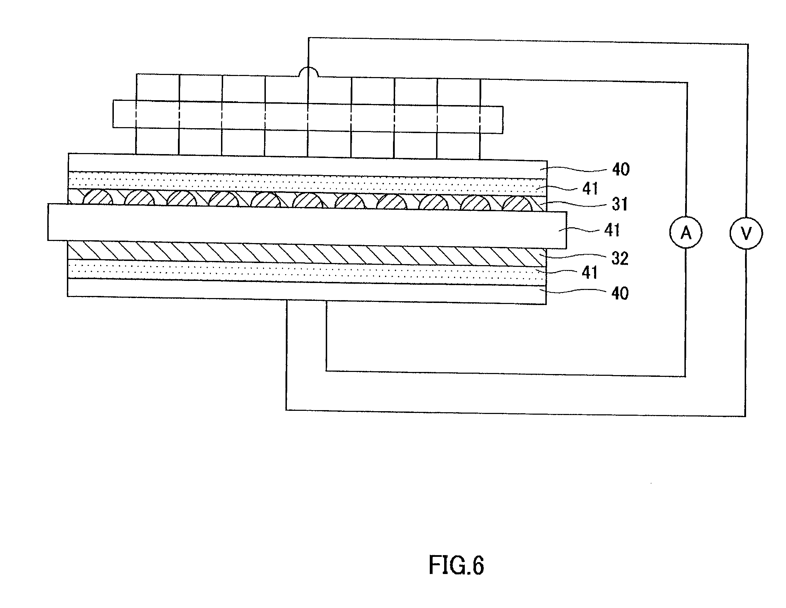

Next, examples of the present invention will be described. As shown in Fig. 6, in the present examples, there were prepared a plural types of samples 41 of electroconductive adhesive films, each having a different material of conductive particles contained in a binder resin, and a plural types of samples 40 of tab leads, each having a different conductor of a base material and a connection surface. Then, via the samples 41 of the electroconductive adhesive films, two samples 40 of the tab leads were hot-pressed and pasted on each of a front surface electrodes 31 and a back surface electrodes 32 formed in photoelectric conversion elements 30 in each of which a front surface electrode 31 and a back surface electrode 32 were formed. In each case, hot-pressing conditions were set at a temperature of 180 degrees C, a pressure of 2 MPa, and a time of 10 sec.

The sample 41 of an electroconductive adhesive film was configured in such a manner that 20 parts by mass of phenoxy resin (YP-50: manufactured by Nippon Steel Chemical Co., Ltd.); 50 parts by mass of liquid epoxy resin (EP828: manufactured by Mitsubishi Chemical Corporation); 10 parts by mass of conductive particles; 20 parts by mass of imidazole potential curing agent (HX3941 HP: manufactured by Asahi Kasei Corporation); and 100 parts by mass of toluene were mixed to prepare a resin composite.

Then, the resin composite was applied to a polyethylene terephthalate film for peeling treatment, the film having a thickness of 50 $\mu$m, so as to have a thickness of 25 $\mu$m, and heated and dried in an oven at 80 degrees C for 5 minutes to be film-formed, whereby the sample 41 of an electroconductive adhesive film was prepared.

Then, for each of solar cells according to the following Examples and Comparative Examples, initial power generation efficiency (%) and generation efficiency (%) after a high temperature and high humidity test (85 degrees C, 85%RH X 3000 hr) were measured by using a solar simulator (solar simulator PVS1116i-M manufactured by Nisshinbo Mechatronics Inc.) under standard measurement conditions (illuminance: 1000 W/m$^2$, temperature: 25 degrees C, and spectrum: AM1.SG). Note that the measurement was performed by using a so-called 4-terminal method, in accordance with JIS C8913 (crystalline solar cell output measurement method).

In Example 1, a front surface electrode 31 and a back surface electrode 32 were formed by applying an Ag paste thereto and being baked. There was used a sample 41 of an electroconductive adhesive film containing Ag particles as conductive particles. Also, there was used a sample 40 of a tab lead obtained by plating a copper-foil base material with lead-free solder (Sn-3Ag-0.5Cu). In Example 1, the surface of the conductive particles was made of the same conductor (Ag) as a conductor constituting the electrodes.

In Example 2, the same solar cell as in Example 1 was used. There was also used a sample 41 of an electroconductive adhesive film, wherein particles obtained by using Ni particles as a core metal and coating an outermost layer thereof with Ag were contained as conductive particles. Also, a sample 40 of the same tab lead as in Example 1 was used. In Example 2, the surface of the conductive particles was made of the same conductor (Ag) as a conductor constituting the electrodes.

In Example 3, the same solar cell as in Example 1 was used. There was also used a sample 41 of an electroconductive adhesive film, wherein particles obtained by using Cu particles as a core metal and coating an outermost layer thereof with Ag were contained as conductive particles. Also, a sample 40 of the same tab lead as in Example 1 was used. In Example 3, the surface of the conductive particles was made of the same conductor (Ag) as a conductor constituting the electrodes.

In Example 4, the same solar cell as in Example 1 was used. There was also used a sample 41 of an electroconductive adhesive film containing lead-free solder (Sn-3Ag-0.5Cu) particles as conductive particles. Also, a sample 40 of the same tab lead as in Example 1 was used. In Example 4, the surface of the conductive particles was made of the same conductor (Sn-3Ag-0.5Cu) as a conductor constituting the connection surface of the tab lead.

In Example 5, the same solar cell as in Example 1 was used. Also, a sample 41 of the same electroconductive adhesive film as in Example 1 was used. There was also used a sample 40 of a tab lead obtained by plating a copper foil base material with Ag. In Example 5, the surface of the conductive particles was made of the same conductor (Ag) as a conductor constituting the connection surface of the tab lead and a conductor constituting the electrodes.

In Example 6, the same solar cell as in Example 1 was used. Also, a sample 41 of the same electroconductive adhesive film as in Example 2 was used. Also, a sample 40 of the same tab lead as in Example 5 was used. In Example 6, the surface of the conductive particles was made of the same conductor (Ag) as a conductor constituting the connection surface of the tab lead and a conductor constituting the electrodes.

In Example 7, the same solar cell as in Example 1 was used. Also, a sample 41 of the same electroconductive adhesive film as in Example 3 was used. Also, a sample 40 of the same tab lead as in Example 5 was used. In Example 7, the surface of the conductive particles was made of the same conductor (Ag) as a conductor constituting the connection surface of the tab lead and a conductor constituting the electrodes.

In Example 8, the same solar cell as in Example 1 was used. There was also used a sample 41 of an electroconductive adhesive film containing lead-containing solder (Sn63-Pb37) particles as conductive particles. There was also used a sample 40 of a tab lead obtained by plating a copper foil base material with lead-containing solder (Sn63-Pb37). In Example 8, the surface of the conductive particles was made of the same conductor (Sn63-Pb37) as a conductor constituting the connection surface of the tab lead.

In Comparative Example 1, the same solar cell as in Example 1 was used. There was used a sample 41 of an electroconductive adhesive film containing Ni particles as conductive particles. Also, a sample 40 of the same tab lead as in Example 1 was used.

In Comparative Example 2, the same solar cell as in Example 1 was used. Also, a sample 41 of the same electroconductive adhesive film as in Example 4 was used. Also, a sample 40 of the same tab lead as in Example 5 was used.

In Comparative Example 3, the same solar cell as in Example 1 was used. Also, a sample 41 of the same electroconductive adhesive film as in Comparative Example 1 was used. Also, a sample 40 of the same tab lead as in Example 5 was used.

In Comparative Example 4, the same solar cell as in Example 1 was used. Also, a sample 41 of the same electroconductive adhesive film as in Example 4 was used. Also, a sample 40 of a tab lead made of only a copper foil base material was used.

In Comparative Example 5, the same solar cell as in Example 1 was used. Also, a sample 41 of the electroconductive adhesive film as in Example 8 was used. Also, a sample 40 of the same tab lead as in Example 5 was used.

In Comparative Example 6, the same solar cell as in Example 1 was used. Also, a sample 41 of the electroconductive adhesive film as in Example 4 was used. Also, a sample 41 of the same tab lead as in Example 8 was used.

In Comparative Example 7, the same solar cell as in Example 1 was used. Also, a sample 41 of the same tab lead as in Example 8 was used. Also, a sample 40 of the electroconductive adhesive film as in Example 1 was used.

In each of Comparative Examples 1 to 7, the surface of the conductive particles was made of a conductor different from a conductor constituting the connection surface of the tab lead and a conductor constituting the electrodes.

For each of solar cells according to Examples 1 to 8 and Comparative Examples 1 to 7, initial power generation efficiency (%) and power generation efficiency (%) after a high temperature and high humidity test (85 degrees C, 85%RH X 3000 hr) were measured to obtain a decreasing rate of power generation efficiency. The results are shown in Table 1. As evaluation indexes, ○ was used to indicate a decreasing rate of power generation efficiency of less than 1.5%, Δ was used to indicate a decreasing rate thereof of not less than 1.5% and less than 3%, and × was used to indicate a decreasing rate thereof of not less than 3%.

[Table 1]

| | | Example 1 | Example 2 | Example 3 | Example 4 | Example 5 | Example 6 | Example 7 | Example 8 |
|---|---|---|---|---|---|---|---|---|---|
| Electrode | Metal of Front Surface Electrode | Ag | Ag | Ag | Ag | Ag | Ag | Ag | Ag |
| | Metal of Back Surface Electrode | Ag | Ag | Ag | Ag | Ag | Ag | Ag | Ag |
| Conductive Particles | Core Metal | Ag | Ni | Cu | Lead-free Solder | Ag | Ni | Cu | Lead-containing Solder |
| | Metal of Outermost Layer | Ag | Ag | Ag | Lead-free Solder | Ag | Ag | Ag | Lead-containing Solder |
| Tab Lead | Metal of Base Material | Cu | Cu | Cu | Cu | Cu | Cu | Cu | Cu |
| | Metal of Plated Layer | Lead-free Solder | Lead-free Solder | Lead-free Solder | Lead-free Solder | Ag | Ag | Ag | Lead-containing Solder |
| Power Generation Efficiency (%) | Initial | 15.67 | 15.81 | 15.55 | 15.49 | 15.87 | 15.87 | 15.72 | 15.66 |
| | After High Temperature and High Humidity Test (85 degrees C, 85%RH × 3000 hr) | 15.51 | 15.64 | 15.41 | 15.3 | 15.76 | 15.74 | 15.61 | 15.46 |
| Decreasing Rate of Power Generation Efficiency (%) | | 1.0 | 1.1 | 0.9 | 1.2 | 0.7 | 0.8 | 0.7 | 1.3 |
| Evaluation | | ○ | ○ | ○ | ○ | ○ | ○ | ○ | ○ |

(continued)

| | | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|
| Electrode | Metal of Front Surface Electrode | Ag | Ag | Ag | Ag | Ag | Ag | Ag |
| | Metal of Back Surface Electrode | Ag | Ag | Ag | Ag | Ag | Ag | Ag |
| Conductive Particles | Core Metal | Ni | Lead-free Solder | Ni | Lead-free Solder | Lead-containing Solder | Lead-free Solder | Lead-containing Solder |
| | Metal of Outermost Layer | Ni | Lead-free Solder | Ni | Lead-free Solder | Lead-containing Solder | Lead-free Solder | Lead-containing Solder |
| Tab Lead | Metal of Base Material | Cu | Cu | Cu | Cu | Cu | Cu | Cu |
| | Metal of Plated Layer | Lead-free Solder | Ag | Ag | / | Ag | Lead-containing Solder | Lead-free Solder |
| Power Generation Efficiency (%) | Initial | 15.82 | 15.57 | 15.73 | 15.84 | 15.65 | 15.42 | 15.69 |
| | After High Temperature and High Humidity Test (85 degrees C, 85%RH × 3000 hr) | 15.30 | 15.23 | 15.13 | 15.27 | 15.27 | 15.13 | 15.28 |
| Decreasing Rate of Power Generation Efficiency (%) | | 3.3 | 2.2 | 3.8 | 3.6 | 2.4 | 1.9 | 2.6 |
| Evaluation | | × | Δ | × | × | Δ | Δ | Δ |

As shown in Table 1, in each of Examples 1 to 8, the decreasing rate of power generation efficiency was less than 1.5%, indicating that the power generation efficiency was maintained high. On the other hand, in Comparative Examples 1 to 7, the decreasing rate of power generation efficiency was not less than 1.5%, indicating the power generation efficiency was considerably reduced. This is considered because, in Comparative Examples, the surface of the conductive particles was made of a different kind of conductor from a conductor constituting the connection surface of the tab lead and a conductor constituting the electrodes, whereby, under a corrosive environment of high temperature and high humidity, so-called contact corrosion between different kinds of metals was caused.

Hence, according to each of Examples 1 to 8, from both viewpoints of power generation efficiency and connection reliability, the solar cell can be put into practical use.

Next, other Examples of the present invention will be explained. Note that, in the following explanation, detailed description of a configuration which is the same as each of the above-mentioned configurations of the solar cell module 1 will be omitted, with assigning the same reference numerals. For the solar cell module explained below, flat conductive particles 43 are used as conductive particles to be contained in a binder resin layer of an electroconductive adhesive film 17.

As is the case with the above-mentioned conductive particles 23, a surface of the conductive particles 43 are also made of the same kind of a conductor as at least any one of a conductor constituting a connection surface of the tab lead 3 and a conductor constituting the bus bar electrode 11 and the back surface electrode 13, preferably made of the same conductor as a conductor constituting a connection surface of the tab lead 3 and a conductor constituting the bus bar electrode 11 and the back surface electrode 13.

The use of the electroconductive adhesive film 17 containing the flat conductive particles 43 secures connection reliability even if hot-pressing at a low pressure is performed, and prevents a cell of the solar cell 2 from being cracked.

Next, examples of the present invention will be explained. In the present examples, there were prepared a plural types of samples of electroconductive adhesive films, each having a different material of conductive particles contained in a binder resin, and, via the samples of electroconductive adhesive films, tab leads were hot-pressed and pasted on a front surface electrode and a back surface electrode of a photoelectric conversion element to produce a solar cell.

The photoelectric conversion element was formed by applying an Ag paste to the front surface electrode and the back surface electrode and being baked. The tab lead was formed by plating a copper-foil base material with lead-free solder (Sn-3Ag-0.5Cu).

The binder resin of the electroconductive adhesive film containing conductive particles was obtained in such a manner that 20 parts by mass of phenoxy resin (YP-50: manufactured by Nippon Steel Chemical Co., Ltd.); 50 parts by mass of liquid epoxy resin (EP828: manufactured by Mitsubishi Chemical Corporation); 10 parts by mass of conductive particles; 20 parts by mass of imidazole potential curing agent (HX3941HP: manufactured by Asahi Kasei Corporation); and 100 parts by mass of toluene were mixed to prepare a resin composite.

This resin composite was mixed with conductive particles according to the following Examples, and applied to a polyethylene terephthalate film for peeling treatment, the film having a thickness of 50 $\mu$m, so as to have a thickness of 25 $\mu$m, and heated and dried in an oven at 80 degrees C for 5 minutes to be film-formed, whereby a sample of an electroconductive adhesive film was prepared.

In Example 9, as conductive particles, there was used a silver-coated copper powder (manufactured by Mitsui Mining & Smelting, Co., LTD., having an elliptical, and an average particle diameter of 5 to 10 micrometers) obtained by displacement-plating a copper powder with silver. An amount of the silver-coated copper powder added was 2 parts by weight with respect to 100 parts by weight of the binder resin. The hot-pressing conditions of the electroconductive adhesive film were set at a temperature of 180 degrees C, a pressure of 2 MPa, and a time of 10 sec.

In Example 10, the same conditions as in Example 9 were used, except that an amount of the silver-coated copper powder added was 5 parts by weight with respect to 100 parts by weight of the binder resin, and a pressure of pressing the electroconductive adhesive film was 1 MPa.

In Example 11, the same conditions as in Example 9 were used, except that an amount of silver-coated copper powder added was 5 parts by weight with respect to 100 parts by weight of the binder resin.

In Example 12, the same conditions as in Example 9 were used, except that an amount of the silver-coated copper powder added was 10 parts by weight with respect to 100 parts by weight of the binder resin, and a pressure of pressing the electroconductive adhesive film was 1 MPa.

In Example 13, the same conditions as in Example 9 were used, except that an amount of the silver-coated copper powder added was 10 parts by weight with respect to 100 parts by weight of the binder resin.

In Example 14, the same conditions as in Example 9 were used, except that an amount of the silver-coated copper powder added was 10 parts by weight with respect to 100 parts by weight of the binder resin, and a pressure of pressing the electroconductive adhesive film was 5 MPa.

Note that the form of conductive particles approximates to a rectangular solid, and when each side of this rectangular solid is classified as a shorter side a, a middle side b, and a longer side c in the shorter order of length, an average particle diameter of the conductive particles is calculated from average values of the shorter sides a, the middle sides b, and the longer sides c, by using the following formula. The shorter side a, the middle side b, and the longer side c is obtained by performing a measurement using a photograph of the predetermined number of conductive particles, for example, 100 conductive particles, taken by a scanning electron microscope and then performing calculation of the average values.

$$\text{Average Particle Diameter of Conductive Particles} = (\text{Average Value of Middle Side } b + \text{Average Value of Longer Side } c) / 2$$

Then, for the solar cell according to each of Examples 9 to 14, there were measured the presence of a cell crack, initial connection resistance (mΩ), and connection resistance (mΩ) after a high temperature and high humidity test (85 degrees C, 85%RH × 500 hr) (mΩ) (Refer to Fig. 6). Table 2 shows the measurement results.

Note that a cell crack was checked by an EL (Electro Luminescence) inspection method making use of EL phenomenon of a solar cell. When no cell crack was observed, this case was evaluated as ○. When less than 10% of cell cracks under the tab lead were caused, this case was evaluated as △. When 10% or more of cell cracks under the tab lead were caused, this case was evaluated as ×.

Connection resistance was measured by a solar simulator (solar simulator PVS11161-M manufactured by Nisshinbo Mechatronics Inc.) under standard measurement conditions (illuminance: 1000 W/m$^2$, temperature: 25 degrees C, and spectrum: AM1.5G), using a so-called 4-terminal method, in accordance with JIS C8913 (crystalline solar cell output measurement method). A connection resistance of less than 4 mΩ was evaluated as ◎; a connection resistance of not less than 4 mΩ and less than 5 mΩ was evaluated as ○; a connection resistance of not less than 5 mΩ and less than 6 mΩ was evaluated as △; and a connection resistance of not less than 6 mΩ was evaluated as ×.

[Table 2]

| | | Example 9 | Example 10 | Example 11 | Example 12 | Example 13 | Example 14 |
|---|---|---|---|---|---|---|---|
| Conductive Particles | | Silver-coated Copper Powder | Silver-coated Copper Powder | Silver-coated Copper Powder | Silver-coated Copper Powder | Silver-coated Copper Powder | Silver-coated Copper Powder |
| Addition Amount (parts by weight) | | 2 | 5 | 5 | 10 | 10 | 10 |
| Compression-bonding Pressure (MPa) | | 2 | 1 | 2 | 1 | 2 | 5 |
| Cell Crack | | ○ | ○ | ○ | ○ | ○ | △ |
| Connection Reliability (85 degrees C, 85%RH) | Initial Stage | ○ | ◎ | ◎ | ○ | ◎ | ○ |
| | 500hr | △ | ◎ | ◎ | △ | ○ | △ |

As shown in Table 2, in Examples 9 to 14, flat conductive particles were used, and therefore, while occurrence of cell crack was controlled with keeping the compression-bonding pressure of an electroconductive adhesive film lower, connection reliability was maintained. Also, in Examples 9 to 14, a silver-coated copper powder having a flat shape was used as conductive particles. Thus, the surfaces of conductive particles are made of the same conductor as a front surface electrode and a back surface electrode which are formed by applying an Ag paste thereto and being baked, and therefore, even if the conductive particles are exposed under a corrosive environment of high temperature and high humidity, a corrosion potential difference between conductors whose standard electrode potentials approximate each other are smaller, and accordingly occurrence of contact corrosion between different kinds of metals can be controlled, and a decrease in power generation efficiency can be prevented, and at the same time, connection reliability can be improved.

Seeing the results of Examples 9 to 14, it is understood that, by adding approximately 5 parts-by-weight of the silver-coated copper powder having a flat shape with respect to 100 parts by weight of the binder resin, good connection reliability can be maintained even under a high temperature and high pressure environment. Note that, in Example 14, the compression-bonding pressure of the electroconductive adhesive film was set somewhat higher, namely, at 5 MPa, and therefore less than 10% of cell cracks under the tab lead were caused, and furthermore, the connection resistance value after a high temperature and humidity test was increased.

Reference Signs List

1...solar cell module, 2...solar cell, 3...tab lead, 4...string, 5...matrix, 6...sheet, 7...front surface cover, 8...back sheet, 9...metal flame, 10...photoelectric conversion element, 11...bus bar electrode, 12...finger electrode, 13...back surface electrode, 14...tab lead connecting portion, 17...electroconductive adhesive film, 22...binder resin, 23...conductive particles, 24...release base material, and 25...reel.

**Claims**

1.  A solar cell module, comprising:

    a plurality of solar cells; and
    at least one tab lead configured to connect the plurality of solar cells to each other in such a manner that each of the at least one tab lead is bonded to an electrode formed on a front surface of corresponding one of the solar cells and to an electrode formed on a back surface of another one of the solar cells which is adjacent to the one of the solar cells, via an electroconductive adhesive containing conductive particles,
    wherein the surfaces of the conductive particles are made of a same kind of a conductor as at least any one of a conductor constituting a connection surface of the at least one tab lead and a conductor constituting the electrode.

2.  The solar cell module according to claim 1, wherein the surfaces of the conductive particles are made of a same conductor as at least any one of a conductor constituting a connection surface of the at least one tab lead and a conductor constituting the electrode.

3.  The solar cell module according to claim 2, wherein the surfaces of the conductive particles are made of a same conductor as both a conductor constituting a connection surface of the at least one tab lead and a conductor constituting the electrode.

4.  The solar cell module according to any one of claims 1 to 3, wherein the surfaces of the conductive particles are made of silver or solder.

5.  The solar cell module according to any one of claims 1 to 4, wherein a core material made of copper is used for the conductive particles.

6.  The solar cell module according to claim 1, wherein conductive particles having a flat shape are used.

7.  The solar cell module according to claim 6, wherein the conductive particles are silver-coated copper particles.

8.  A method of manufacturing a solar cell module, the method comprising the steps of:

    arranging one end portion of a tab lead on a front surface electrode of a solar cell via an electroconductive adhesive containing conductive particles, while arranging an other end portion of the tab lead on a back surface electrode of another solar cell adjacent to said solar cell via an electroconductive adhesive containing conductive particles; and
    hot-pressing the tab lead on the front surface electrode and the back surface electrode, thereby bonding the tab lead to the front surface electrode and the back surface electrode by the electroconductive adhesive,
    wherein the surfaces of the conductive particles are made of a same kind of a conductor as at least any one of a conductor constituting a connection surface of the tab lead and a conductor constituting the electrode.

9.  The method of manufacturing a solar cell module according to claim 8, wherein the surfaces of the conductive particles are made of a same conductor as at least any one of a conductor constituting a connection surface of the tab lead and a conductor constituting the electrode.

**10.** The method of manufacturing a solar cell module according to claim 9, wherein the surfaces of the conductive particles are made of a same conductor as a conductor constituting a connection surface of the tab lead and a conductor constituting the electrode.

FIG.1

FIG.2

FIG.3

FIG.4

FIG.5

FIG.6

FIG.7

FIG.8

<div align="center">

**INTERNATIONAL SEARCH REPORT**

</div>

| | International application No. |
|---|---|
| | PCT/JP2012/051260 |

**A. CLASSIFICATION OF SUBJECT MATTER**
*H01L31/042*(2006.01)i

According to International Patent Classification (IPC) or to both national classification and IPC

**B. FIELDS SEARCHED**

Minimum documentation searched (classification system followed by classification symbols)
H01L31/042

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2007-158302 A (Hitachi Chemical Co., Ltd.), 21 June 2007 (21.06.2007), paragraphs [0026], [0032], [0043]; fig. 2 to 3 & EP 2086023 A1 & WO 2008/044357 A1 & CA 2666404 A & CN 101529603 A & CN 101997059 A | 1-10 |
| Y | JP 2001-345469 A (Canon Inc.), 14 December 2001 (14.12.2001), paragraphs [0078], [0083], [0085] & US 2002/0139415 A1 | 1-10 |
| Y | JP 7-99334 A (Canon Inc.), 11 April 1995 (11.04.1995), paragraph [0083] (Family: none) | 5,7 |

☒ Further documents are listed in the continuation of Box C.   ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>03 February, 2012 (03.02.12) | Date of mailing of the international search report<br>14 February, 2012 (14.02.12) |
|---|---|
| Name and mailing address of the ISA/<br>   Japanese Patent Office | Authorized officer |
| Facsimile No. | Telephone No. |

Form PCT/ISA/210 (second sheet) (July 2009)

**INTERNATIONAL SEARCH REPORT**

| International application No. |
| --- |
| PCT/JP2012/051260 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | WO 2008/078374 A1 (Namics Corp.), 03 July 2008 (03.07.2008), paragraph [0039] & US 2010/0096014 A1 | 5,7 |
| Y | WO 2010/109905 A1 (Hitachi Powdered Metals Co., Ltd.), 30 September 2010 (30.09.2010), paragraphs [0036], [0040] (Family: none) | 5,7 |

Form PCT/ISA/210 (continuation of second sheet) (July 2009)

# EP 2 667 420 A1

| INTERNATIONAL SEARCH REPORT | International application No. |
|---|---|
| | PCT/JP2012/051260 |

Claims 1 and 4-8 prescribe that "the surface of the conductive particles is composed of the same type of conductor as the conductor composing the connection surface of the tab wire and/or the electrode," but it is unclear what kind of conductor is applicable to "the same type of conductor."

It is written, in paragraph [0015] of the specification of the present invention, "that is, a conductor whose standard electrode potential closely resembles the conductor" as a definition of "the same type of conductor," but since it is unclear which two of the standard electrode potentials of Ag, Cu, Au, Fe, Ni, Sn are assumed to closely resemble each other, and which two are assumed not to closely resembles each other, for example, it cannot be ascertained to what extent "closely resemble" includes discrepancy therefrom, in this context, and as a result, the meaning of "the same type of conductor" has also become unclear.

Therefore, this search has been made only for "the same" conductors, not "the same type" of conductors.

Form PCT/ISA/210 (extra sheet) (July 2009)

**EP 2 667 420 A1**

**REFERENCES CITED IN THE DESCRIPTION**

**Patent documents cited in the description**

- JP 2011010232 A
- JP 2011169446 A
- JP 2004356349 A
- JP 2008135654 A